# EUROPÄISCHE PATENTANMELDUNG

(11) **EP 2 051 571 A2**
(43) Veröffentlichungstag der Anmeldung: **22.04.2009**
(21) Anmeldenummer: 08014171.6
(22) Anmeldetag: 08.08.2008
(51) Int. Cl.: H05K 5/00

(54) **Leistungsmodul**

(30) Priorität: 21.09.2007 DE 102007045281
(71) Anmelder: SEMIKRON Elektronik GmbH & Co. KG, 90431 Nürnberg (DE)
(72) Erfinder: Reusser, Lars, 96114 Hirschaid (DE); Lederer, Marco, 90453 Nürnberg (DE)

(57) **Zusammenfassung**

Es wird ein Leistungsmodul mit einem Substrat (12) beschrieben, das an einer Hauptfläche (16) Schaltungsbahnen (18) und Bauelemente aufweist. Ein becherförmiges Gehäuse (10) liegt mit seinem Unterrand (30) am Rand (32) des Substrates (12) verdrehgesichert an. Das becherförmige Gehäuse (10) weist mindestens ein Hülsenelement (36) auf, das für ein Druckverbindungselement vorgesehen ist, mit welchem eine Druckeinrichtung gegen eine Leiterplatte und diese gegen das becherförmige Gehäuse (10) und dieses mit dem Substrat (12) gegen einen Kühlkörper gezwängt wird. Um auch bei einem ausgewölbten Substrat (12) eine zuverlässige Verdrehsicherung zwischen diesem und dem Unterrand (30) des becherförmigen Gehäuses (10) zu bewerkstelligen, ist das mindestens eine Hülsenelement (36) in einer mit dem Gehäuse (10) materialeinstückig ausgebildeten Führung (34) axial beweglich vorgesehen und endet das unterseitige Ende (38) der Führung (34) vom Substrat (12) beabstandet.

## Beschreibung

Die Erfindung betrifft ein Leistungsmodul mit einem Substrat, das an einer Hauptfläche Schaltungsbahnen und Bauelemente aufweist und mit mindestens einem Loch für ein Druckverbindungselement ausgebildet ist, und mit einem becherförmigen Gehäuse für Druckkontaktfederelemente, das mit seinem Unterrand am Rand des Substrates anliegt und das mindestens ein Hülsenelement aufweist, das mit einem zugehörigen, für ein Druckverbindungselement vorgesehenem Loch des Substrates axial fluchtet. Dabei sind die Druckkontaktfederelemente zur Kontaktierung des Substrates mit einer auf dem Gehäuse angeordneten Leiterplatte vorgesehen. Eine Druckeinrichtung ist mittels des mindestens einen Druckverbindungselementes zum Verspannen der Leiterplatte mit dem Gehäuse und dem Substrat mit einem Kühlkörper vorgesehen.

Ein derartiges Leistungsmodul ist beispielsweise aus der DE 196 30 173 A1 bekannt. Bei diesem bekannten Leistungsmodul ist das mindestens eine Hülsenelement für das Druckverbindungselement mit dem becherförmigen Gehäuse materialeinstückig ausgebildet.

Ein Leistungsmodul, bei welchem das mindestens eine Hülsenelement für ein zugehöriges Druckverbindungselement mit dem becherförmigen Gehäuse materialeinstückig ausgebildet ist, ist beispielsweise auch aus der DE 103 06 643 A1 bekannt.

Das Substrat derartiger Leistungsmodule besteht üblicherweise aus einem Keramikkörper, der an der einen Hauptfläche Schaltungsbahnen und Bauelemente und auf der gegenüberliegenden zweiten Hauptfläche eine die Verlustwärme des Leistungsmoduls zum Kühlkörper ableitende Metallschicht aufweist. Bei Substraten aus einem Keramikkörper sind jedoch durch das Herstellungsverfahren bedingte Auswölbungen des Substrates nicht zuverlässig ausschließbar. Kommt ein solches ausgewölbtes Substrat zur Anwendung, so ist eine unerwünschte Verdrehung des Substrates in Bezug zum becherförmigen Gehäuse oftmals nicht vermeidbar, weil das Substrat bei der Montage zuerst mit dem Unterrand des gehäusefesten Hülsenelementes des becherförmigen Gehäuses in Berührung kommt, während der Rand des Substrates vom Unterrand des becherförmigen Gehäuses beabstandet bleibt, so dass ein eine Verdrehsicherung bewirkender Formschluss zwischen dem Rand des Substrates und dem Unterrand des becherförmigen Gehäuses nicht gegeben ist.

In Kenntnis dieser Gegebenheiten liegt der Erfindung die Aufgabe zugrunde, ein Leistungsmodul der eingangs genannten Art zu schaffen, das einfach ausgebildet beim Zusammenbau des Leistungsmoduls zuverlässig eine Verdrehsicherung zwischen dem becherförmigen Gehäuse und dem Substrat auch dann gewährleistet, wenn das Substrat eine herstellungsbedingte Auswölbung aufweist.

Diese Aufgabe wird bei einem Leistungsmodul der eingangs genannten Art erfindungsgemäß dadurch gelöst, dass das mindestens eine Hülsenelement in einer mit dem becherförmigen Gehäuse materialeinstückig ausgebildeten Führung nach unten begrenzt axial beweglich vorgesehen ist, wobei das unterseitige Ende der gehäusefesten Führung vom Substrat definiert beabstandet endet.

Dadurch, dass erfindungsgemäß das mindestens eine Hülsenelement mit dem becherförmigen Gehäuse nicht materialeinstückig ausgebildet sondern in einer mit dem becherförmigen Gehäuse materialeinstückig ausgebildeten Führung axial begrenzt beweglich vorgesehen ist, wird durch das Hülsenelement die eine Verdrehsicherung bewirkende formschlüssige Verbindung zwischen dem Unterrand des becherförmigen Gehäuses und dem Rand des Substrates nicht behindert. Auch wenn das Substrat herstellungsbedingt ausgewölbt ist, ergibt sich folglich in vorteilhafter Weise zwischen dem becherförmigen Gehäuse und dem Substrat bei der Montage des Leistungsmoduls eine zuverlässige Verdrehsicherung. Ein weiterer Vorteil des erfindungsgemäßen Leistungsmoduls besteht darin, dass sich auch eine bei dem erfindungsgemäßen Leistungsmodul zur Anwendung gelangende Wärmeleitpaste zwischen der wärmeableitenden Metallschicht des Substrates und dem Kühlkörper im zusammengebauten Zustand des Leistungsmoduls sehr gleichmäßig verteilt.

Als zweckmäßig hat es sich bei dem erfindungsgemäßen Leistungsmodul erwiesen, wenn die Führung für das Hülsenelement an ihrem unteren Endabschnitt innenseitig einen Bund aufweist, der mit axial orientierten Führungskanälen ausgebildet ist, und wenn das zugehörige, axial bewegliche Hülsenelement unterseitig mit Druckfingern ausgebildet ist, die sich geführt durch die Führungskanäle bis zur ersten Hauptfläche des Substrates erstrecken. Dabei ist es bevorzugt, wenn die Führungskanäle und die Druckfinger in Umfangsrichtung gleichmäßig verteilt vorgesehen sind.

Die Führungskanäle sind voneinander durch Stege beabstandet, deren Breite in Umfangsrichtung kleiner ist als die lichte Breite der Führungskanäle in Umfangsrichtung. Zur einfachen und zeitsparenden Handhabung des mindestens einen Druckverbindungselementes, das zweckmäßigerweise von einem Gewindestift bzw. einer Schraube gebildet ist, hat es sich als zweckmäßig erwiesen, wenn das axial bewegliche Hülsenelement einen für das zugehörige Verbindungselement vorgesehenen Führungsabschnitt und der am unteren Endabschnitt der für das axial bewegliche Hülsenelement vorgesehenen Führung ausgebildete Bund aneinander mindestens annähernd angepasste lichte Querschnittsabmessungen aufweisen.

An den Führungsabschnitt des Hülsenelementes schließt zweckmäßigerweise oberseitig eine Erweiterung an, die für ein Zentrierelement der Druckeinrichtung vorgesehen ist. Durch eine solche Ausbildung ergibt sich eine einfache und zeitsparende Zentrierung der Druckeinrichtung in Bezug zum becherförmigen Gehäuse des Leistungsmoduls.

Das becherförmige Gehäuse des erfindungsgemäßen Leistungsmoduls ist am oberseitigen Endabschnitt der mindestens einen Führung vorzugsweise mit einer Erweiterung und das zugehörige, axial bewegliche Hülsenelement ist vorzugsweise mit einer der Erweiterung formmäßig entsprechenden Verdickung ausgebildet. Diese Erweiterung und die besagte Verdickung können kegelstumpfförmig ausgebildet sein.

Außerdem kann die Erweiterung mindestens eine Verdrehsicherungsnoppe und die Verdickung des Hülsenelementes mindestens eine der Verdrehsicherungsnoppe entsprechende Aussparung aufweisen. Durch eine solche Ausbildung ergibt sich beim Zusammenbau eine optimale Verdrehsicherung zwischen der mindestens einen Führung des Gehäuses und dem in dieser axial beweglichen Hülsenelement.

Bevorzugt ist es, wenn das axial bewegliche Hülsenelement oberseitig mit einem über die Gehäuseoberseite überstehenden Zentrierbund für eine eingangs erwähnte Leiterplatte ausgebildet ist. Der Zentrierbund kann mit einem Verdrehsicherungsrand, d.h. gewellt, genoppt oder dergleichen, ausgebildet sein.

Weitere Einzelheiten, Merkmale und Vorteile ergeben sich aus der nachfolgenden Beschreibung wesentlicher Einzelheiten des erfindungsgemäßen Leistungsmoduls.

Es zeigen:
- Figur 1: einen Schnitt durch das becherförmige Gehäuse mit seiner Führung und dem in der Führung axial beweglich vorgesehenen Hülsenelement und durch das Substrat, wobei das Hülsenelement mit seiner Verdickung aus der Oberseite des becherförmigen Gehäuses vorsteht,
- Figur 2: eine der Figur 1 ähnliche Schnittdarstellung, wobei die Verdickung des Hülsenelementes mit der Oberseite des becherförmigen Gehäuses bündig d.h. ebenflächig abschließt,
- Figur 3: eine Schnittansicht des becherförmigen Gehäuses - ohne das zugehörige Hülsenelement - und des Substrates,
- Figur 4: einen Längsschnitt durch das Hülsenelement gemäß den Figuren 1 und 2 in einem größeren Maßstab, und
- Figur 5: eine perspektivische Ansicht des Hülsenelementes.

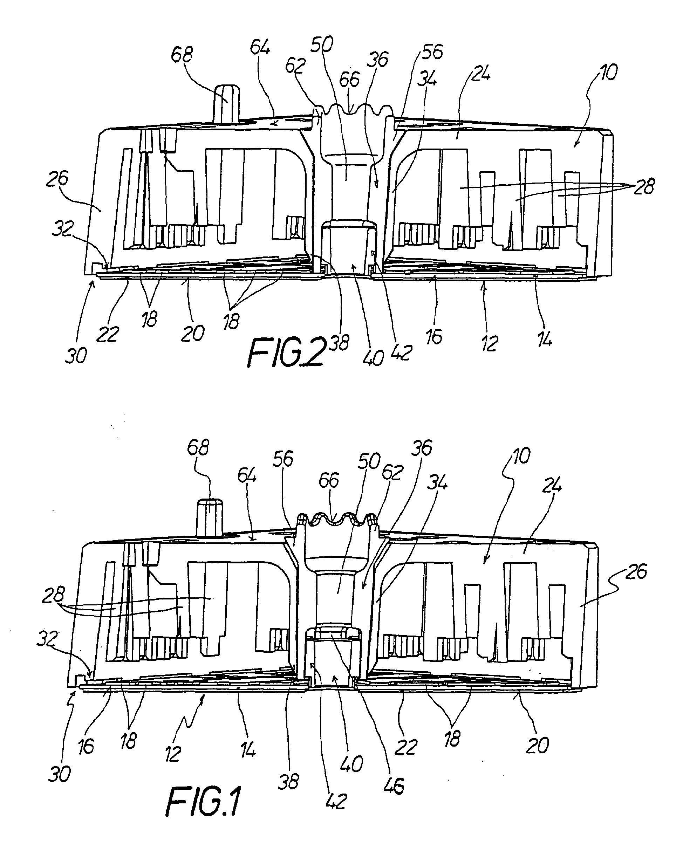

Figur 1 zeigt in einer Schnittdarstellung eine Ausbildung eines becherförmigen Gehäuses 10 und eines zugehörigen Substrates 12 eines Leistungsmoduls. Bei dem Substrat 12 handelt es sich zweckmäßigerweise um ein DCB (Direct Copper Bonding)-Substrat, das in an sich bekannter Weise von einer Platte 14 aus einem Keramikmaterial gebildet ist, die an ihrer dem becherförmigen Gehäuse 10 zugewandten ersten Hauptfläche 16 Schaltungsbahnen 18 und Bauelemente und an der gegenüberliegenden - einem (nicht gezeichneten) Kühlkörper zugewandten - zweiten Hauptfläche 20 eine Metallschicht 22 aufweist, die zum Ableiten von Verlustwärme zum nicht dargestellten Kühlkörper vorgesehen ist.

Das becherförmige Gehäuse 10 weist einen Deckelabschnitt 24 und eine den Deckelabschnitt 24 außenseitig umschließende Seitenwandung 26 auf. Vom Deckelabschnitt 24 stehen innenseitig integral Führungskanäle 28 nach innen, die für nicht dargestellte Druckkontaktfederelemente vorgesehen sind. Diesbezüglich wird beispielhaft auf die eingangs zitierte DE 103 06 643 A1 verwiesen.

Das becherförmige Gehäuse 10 ist an der umlaufenden Seitenwandung 26 mit einem Unterrand 30 ausgebildet, der im zusammengebauten Zustand des Leistungsmoduls am Rand 32 des Substrates 12 verdrehgesichert anliegt.

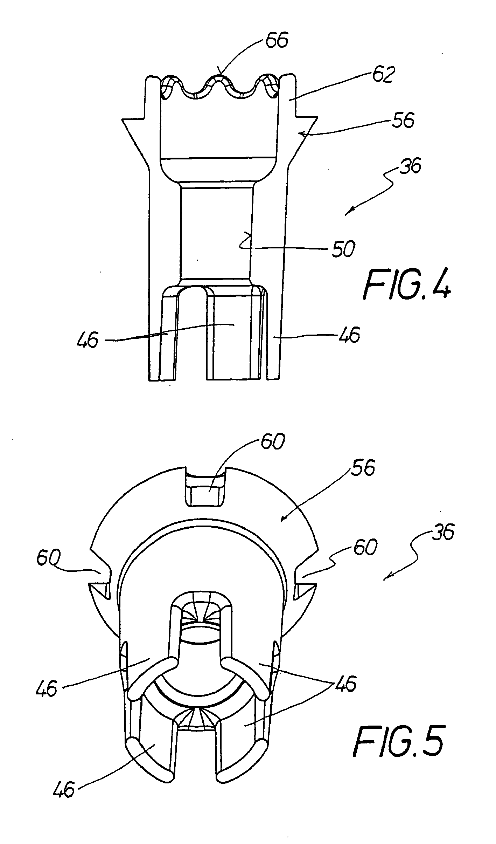

Das becherförmige Gehäuse 10 ist materialeinstückig mit einer hülsenförmigen Führung 34 ausgebildet, in der ein Hülsenelement 36 (siehe auch Figur 2 und insbesondere die Figuren 4 und 5) axial begrenzt beweglich vorgesehen ist. Die Führung 34 steht vom Deckelabschnitt 24 des becherförmigen Gehäuses 10 in die gleiche Richtung wie die Seitenwandung 26 und die Führungskanäle 28, d.h. nach unten, weg. Das unterseitige Ende 38 der Führung 34 ist vom Substrat 12 jederzeit geringfügig beabstandet.

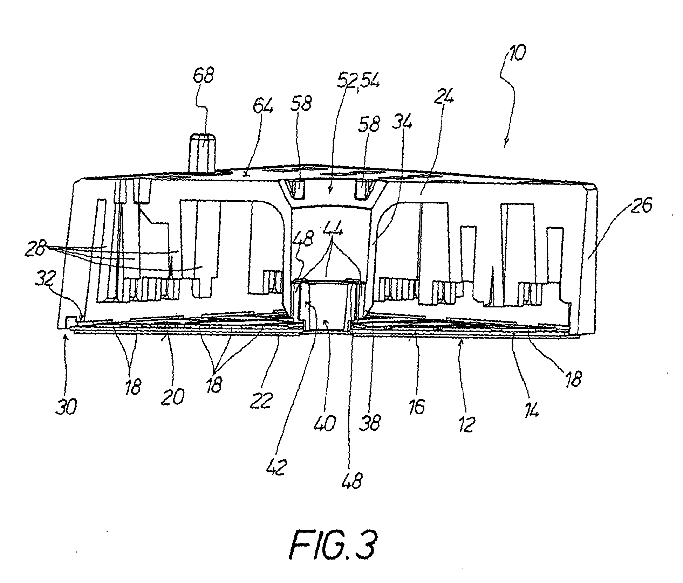

Wie aus Figur 3 deutlich ersichtlich ist, ist die hülsenartige Führung 34 an ihrem unteren Endabschnitt 40 innenseitig mit einem Bund 42 ausgebildet. Der Bund 42 ist mit axial orientierten Führungskanälen 44 ausgebildet. Das Hülsenelement 36 ist unterseitig mit Druckfingern 46 ausgebildet, die aus Figur 4 und insbesondere aus Figur 5 deutlich ersichtlich sind. Die Druckfinger 46 erstrecken sich geführt durch die im Bund 42 der hülsenförmigen Führung 34 ausgebildeten Führungskanäle 44 hindurch.

Während das unterseitige Ende 38 der Führung 34 - wie bereits erwähnt worden ist - vom Substrat 12 jederzeit definiert beabstandet ist, erstrecken sich die Druckfinger 46 des Hülsenelementes 36 bis zum Substrat 12, d.h. sie liegen an dessen erster Hauptfläche 16 an.

Die Führungskanäle 44 und die in diesen spielfrei vorgesehenen Druckfinger 46 sind in Umfangsrichtung gleichmäßig verteilt vorgesehen. Die Führungskanäle 44 sind voneinander durch Stege 48 beabstandet. Die Breite der Stege 44 ist in Umfangsrichtung kleiner als die lichte Breite der Führungskanäle 44 in Umfangsrichtung (siehe Figur 3).

Das axial bewegliche Hülsenelement 36 weist einen Führungsabschnitt 50 für das zugehörige (nicht dargestellte) Druckverbindungselement auf. Der Bund 42 der Führung 34 des becherförmigen Gehäuses 10 ist mit einem lichten Querschnitt ausgebildet, der an den lichten Querschnitt des besagten Führungsabschnittes 50 mindestens annähernd angepasst ist, wie die Figuren 1 und 2 verdeutlichen.

Wie aus Figur 3 ersichtlich ist, ist das becherförmige Gehäuse 10 am oberseitigen Endabschnitt 52 der Führung 34 mit einer kegelstumpfförmigen Erweiterung 54 ausgebildet. Das zugehörige Hülsenelement 36 ist mit einer an die Erweiterung 54 formmäßig angepassten Verdickung 56 (siehe beispielsweise die Figuren 4 und 5) ausgebildet. Die Erweiterung 54 ist mit Verdrehsicherungsnoppen 58 (siehe Figur 3) und die Verdickung 56 des Hülsenelementes 36 ist mit den Verdrehsicherungsnoppen 58 entsprechenden Aussparungen 60 (siehe Figur 5) ausgebildet.

Das Hülsenelement 36 ist oberseitig mit einem Zentrierbund 62 für eine in den Zeichnungen ebenfalls nicht dargestellte Leiterplatte ausgebildet. Der Zentrierbund 62 steht über die den Deckelabschnitt 24 oberseitig begrenzende Gehäuseoberseite 64 über. Der Zentrierbund 62 ist mit einem gewellten Verdrehsicherungsrand 66 ausgebildet.

Beim Zusammenbau des Leistungsmoduls wird in einem ersten Arbeitsschritt das Substrat 12 an der Unterseite des becherförmigen Gehäuses 10 angeordnet. Dabei kommen zuerst die Druckfinger 46 des Hülsenelementes 36 am Substrat 12 zur Anlage, wenn dieses sinterbedingt aufgewölbt ist. Dadurch, dass das Hülsenelement 36 in der Führung 34 des becherförmigen Gehäuses 10 axial beweglich ist, ist es in vorteilhafter Weise problemlos möglich, dass das Substrat 12 mit seinem Rand 32 am Unterrand 30 der Seitenwandung 26 des becherförmigen Gehäuses 10 formschlüssig und somit verdrehsicher zur Anlage kommt.

Anschließend wird auf der Gehäuseoberseite 64 eine Schaltungsplatte positioniert. Zur genau passenden Positionierung der besagten Schaltungsplatte dient neben dem Zentrierbund 62 des Hülsenelementes 36 ein von der Gehäuseoberseite 64 nach oben stehender Positionierzapfen 68. Durch die genaue Positionierung der Leiterplatte ergibt sich eine passgenaue Kontaktierung derselben mittels der in den Führungskanälen 28 befindlichen (nicht dargestellten) Druckkontaktfederelemente mit dem Substrat 12. Die Druckkontaktierung zwischen der Leiterplatte und dem Substrat 12 erfolgt mit Hilfe einer Druckeinrichtung, die in den Zeichnungsfiguren ebenfalls nicht dargestellt ist, und die mittels sich durch das Hülsenelement 36 und den Bund 42 hindurch erstreckenden Druckverbindungselementen zwischen der Druckeinrichtung und einem Kühlkörper eine form- und kraftschlüssige Verbindung herstellt.

In den Zeichnungsfiguren sind alle Einzelheiten jeweils mit denselben Bezugsziffern bezeichnet, so dass es sich erübrigt, in Verbindung mit allen Figuren alle Einzelheiten jeweils detailliert zu beschreiben.

### Bezugsziffernliste:

- 10: becherförmiges Gehäuse
- 12: Substrat
- 14: Platte (von 12)
- 16: erste Hauptfläche (von 14)
- 18: Schaltungsbahnen (an 16)
- 20: zweite Hauptfläche (von 14)
- 22: Metallschicht (an 20)
- 24: Deckelabschnitt (von 10)
- 26: umlaufende Seitenwandung (von 10)
- 28: Führungskanäle (an 24)
- 30: Unterrand (von 10 bzw. 26)
- 32: Rand (von 12)
- 34: Führung (von 10 für 36)
- 36: Hülsenelement (in 34)
- 38: unterseitiges Ende (von 34)
- 40: unterer Endabschnitt (von 34)
- 42: Bund (bei 40)
- 44: Führungskanäle (in 42 für 46)
- 46: Druckfinger (von 36)
- 48: Stege (zwischen 44 und 44)
- 50: Führungsabschnitt (von 36)
- 52: oberseitiger Endabschnitt (von 34)
- 54: Erweiterung (bei 52 für 56)
- 56: Verdickung (von 36)
- 58: Verdrehsicherungsnoppen (von 54)
- 60: Aussparungen (in 56 für 58)
- 62: Zentrierbund (von 36)
- 64: Gehäuseoberseite (von 10)
- 66: Verdrehsicherungsrand (von 62)
- 68: Positionierzapfen (an 64)

## Patentansprüche

1. Leistungsmodul mit einem Substrat (12), das an einer Hauptfläche (16) Schaltungsbahnen (18) und Bauelemente aufweist, und das mit mindestens einem Loch für ein Druckverbindungselement ausgebildet ist, und mit einem becherförmigen Gehäuse (10) für Druckkontaktfederelemente, das mit seinem Unterrand (30) am Rand (32) des Substrates (12) anliegt und mindestens ein Hülsenelement (36) aufweist, das mit einem zugehörigen, für das Druckverbindungselement vorgesehenem Loch des Substrates (12) axial fluchtet,
**dadurch gekennzeichnet,**
**dass** das mindestens eine Hülsenelement (36) in einer mit dem becherförmigen Gehäuse (10) materialeinstückig ausgebildeten Führung (34) nach unten begrenzt axial beweglich vorgesehen ist, deren unterseitiges Ende (38) vom Substrat (12) beabstandet endet.

2. Leistungsmodul nach Anspruch 1,
**dadurch gekennzeichnet,**
**dass** die Führung (34) an einem unteren Endabschnitt (40) innenseitig einen Bund (42) aufweist, der mit axial orientierten Führungskanälen (44) ausgebildet ist, und dass das zugehörige, axial bewegliche Hülsenelement (36) unterseitig mit Druckfingern (46) ausgebildet ist, die sich geführt durch die Führungskanäle (44) bis zur ersten Hauptfläche (16) des Substrates (12) erstrecken.

3. Leistungsmodul nach Anspruch 2,
**dadurch gekennzeichnet,**
**dass** die Führungskanäle (44) und die Druckfinger (46) in Umfangsrichtung gleichmäßig verteilt vorgesehen sind.

4. Leistungsmodul nach Anspruch 2,
**dadurch gekennzeichnet,**
**dass** die Führungskanäle (44) voneinander durch Stege (48) beabstandet sind, deren Breite in Umfangsrichtung kleiner ist als die lichte Breite der Führungskanäle (44) in Umfangsrichtung.

5. Leistungsmodul nach einem der Ansprüche 2 bis 4,
**dadurch gekennzeichnet,**
**dass** das axial bewegliche Hülsenelement (36) einen für das zugehörige Druckverbindungselement vorgesehenen Führungsabschnitt (50) und der am unteren Endabschnitt (40) der Führung (34) vorgesehene Bund (42) aneinander mindestens annähernd angepasste lichte Querschnittsabmessungen aufweisen.

6. Leistungsmodul nach Anspruch 5,
**dadurch gekennzeichnet,**
**dass** an den Führungsabschnitt (50) des Hülsenelementes (36) oberseitig eine Erweiterung anschließt, die für ein Zentrierelement der Druckeinrichtung vorgesehen ist.

7. Leistungsmodul nach einem der Ansprüche 1 bis 6,
**dadurch gekennzeichnet,**
**dass** das becherförmige Gehäuse (10) am oberseitigen Endabschnitt (52) der mindestens einen Führung (34) mit einer Erweiterung (54) und das zugehörige, axial bewegliche Hülsenelement (36) mit einer an die Erweiterung (54) formmäßig angepassten Verdickung (56) ausgebildet ist.

8. Leistungsmodul nach Anspruch 7,
**dadurch gekennzeichnet,**
**dass** die Erweiterung (54) und die Verdickung (56) kegelstumpfförmig ausgebildet sind.

9. Leistungsmodul nach Anspruch 7 oder 8,
**dadurch gekennzeichnet,**
**dass** die Erweiterung (54) mindestens eine Verdrehsicherungsnoppe (58) und die Verdickung (56) mindestens eine an die Verdrehsicherungsnoppe (58) formmäßig angepasste Aussparung (60) aufweist.

10. Leistungsmodul nach einem der Ansprüche 1 bis 9,
**dadurch gekennzeichnet,**
**dass** das axial bewegliche Hülsenelement (36) oberseitig mit einem über die Gehäuseoberseite (64) des becherförmigen Gehäuses (10) überstehenden Zentrierbund (62) für die Leiterplatte ausgebildet ist.

11. Leistungsmodul nach Anspruch 10,
**dadurch gekennzeichnet,**
**dass** der Zentrierbund (62) mit einem Verdrehsicherungsrand (66) ausgebildet ist.
